# FASCICULE DE BREVET EUROPEEN

(11) **EP 2 561 619 B1**
(45) Date de publication et mention de la délivrance du brevet: **20.06.2018**
(21) Numéro de dépôt: 11720144.2
(22) Date de dépôt: 11.04.2011
(51) Int. Cl.: H04B 1/38, H05K 9/00

(54) **DISPOSITIF DE PROTECTION CONTRE DES ONDES ÉLECTROMAGNÉTIQUES**
VORRICHTUNG ZUM SCHUTZ VOR ELEKTROMAGNETISCHEN WELLEN
DEVICE FOR PROTECTION AGAINST ELECTROMAGNETIC WAVES

(30) Priorité: 21.04.2010 FR 1053050
(43) Date de publication de la demande: 27.02.2013
(73) Titulaire: Dephasium, 75001 Paris (FR); Université de Nantes, 44035 Nantes Cedex 1 (FR)
(72) Inventeur: PARIENTI, Serge, F-92100 Boulogne-Billancourt (FR); MOURALI, Cyril, F-75017 Paris (FR); SAILLARD, Joseph, F-44800 Saint Herblain (FR); CHAUVEAU, Janic, F-35390 Grand Fougeray (FR); BRUNET, Marc, F-44450 Saint Julien de Concelles (FR)
(74) Mandataire: Louiset, Raphaël
(86) Numéro de dépôt international: PCT/FR2011/050821
(87) Numéro de publication internationale: WO 2011/131891

(56) Documents cités:
- WO-A1-02/095867
- DE-U1- 20 106 637
- DE-U1- 20 306 964
- US-A1- 2002 137 475

## Description

La présente invention concerne le domaine des dispositifs de protection biologique individuelle contre les émissions de pollution électromagnétique et plus particulièrement les dispositifs de protection adaptés pour terminaux mobiles et comprenant un élément de protection en plusieurs parties.

A l'heure actuelle, les terminaux mobiles utilisés pour communiquer utilisent un rayonnement électromagnétique pour permettre une connexion sans fils constante avec un réseau adapté, que ces terminaux soient des téléphones, des ordinateurs, des modems WIFI ou des accessoires Bluetooth.

La multiplication, dans notre environnement, de ces terminaux mobiles pour communiquer pose la question concrète des effets sur la santé et le cas du téléphone mobile est le plus significatif. Tant qu'aucune réponse concrète et définitive n'a pu être trouvée pour démontrer la question de la nocivité, la polémique conserve un terrain favorable pour rester maintenue.

Pour éviter toute polémique, les conditions de fonctionnement des téléphones mobiles sont encadrées par textes de loi en restreignant, par exemple, l'indice de débit d'absorption spécifique (DAS), qui est la grandeur fondamentale associée à l'échauffement des tissus, à certaines plages de valeurs.

Toutefois, compte-tenu du manque de recul et des incertitudes qui persistent encore actuellement quant au véritable seuil de tolérance du DAS chez l'homme et dans un principe de précaution, des dispositifs de protection biologique individuelle, par exemple des boîtiers permettant de limiter l'exposition aux pollutions électromagnétiques sur l'organisme, apparaissent sur le marché.

Ainsi, dans le domaine des boîtiers de protection adaptés pour les terminaux mobiles tels que les téléphones portables, plusieurs systèmes ont différents spectres de fréquences des ondes électromagnétiques, en positionnant cette protection entre l'équipement de technologie mobile et l'utilisateur.

La protection de ces boîtiers peut parfois être formée de plusieurs parties qui s'articulent entre elles entre une position ouverte, lorsque l'utilisateur a besoin d'avoir accès à l'écran du terminal, et une position fermée, lorsque l'utilisateur est en cours de communication avec le terminal positionné contre son oreille. Cependant, de tels boîtiers de protection, du fait d'une construction à partir de plusieurs éléments qui doivent être en mesure de s'articuler entre eux, peuvent présenter un défaut d'étanchéité à l'égard des ondes électromagnétiques lorsque le dispositif de protection est refermé.

Le document US 2002/137475 divulgue un boitier de protection contre les ondes électromagnétiques pour un téléphone mobile. Ce boitier est composé d'un premier coffrage et d'un second coffrage destiné à recevoir le téléphone mobile. Le premier coffrage comprend une partie ne faisant pas obstacle aux ondes, de manière à permettre l'émission et la réception de signaux par le téléphone. Le second coffrage comprend un trou disposé au niveau du haut parleur du téléphone. Cependant, ce boitier peut présenter un défaut d'étanchéité en raison de la nature même du boitier, composé de plusieurs éléments s'articulant entre eux.

Le document DE 20306964 divulgue un écran déflecteur monté entre l'utilisateur d'un téléphone mobile et le téléphone lui-même, et comporte un écran métallique ou un écran composé d'un métal à plusieurs faces métalliques. La face métallique de l'écran déflecteur, face au téléphone mobile, est de forme hyperbolique tandis que l'écran déflecteur comporte un conducteur métallique couplé au contact de masse du téléphone. Cependant, une telle solution n'est pas un boitier de protection, et des problèmes d'étanchéité peuvent également survenir.

La présente invention a pour but de pallier un ou plusieurs des inconvénients de l'art antérieur en proposant un dispositif de protection biologique contre au moins certaines des ondes électromagnétiques émises par un terminal mobile, ce dispositif étant formé de plusieurs pièces qui s'articulent entre elles et garantissent une étanchéité à l'égard des ondes électromagnétiques émises lorsque ce dispositif de protection est en mode fermé.

Ce but est atteint par un dispositif de protection contre des ondes électromagnétiques émises par un termina! mobile formant un boîtier comportant au moins une face de protection métallique adapté pour entourer le terminal et ce boîtier comprenant au moins une première pièce arrangée pour définir un cadre métallique de protection destiné à recevoir le terminal et une seconde pièce qui forme un volet de protection amovible s'articulant avec le cadre de la première partie pour rendre étanche au moins une face de protection du boitier de protection, caractérisé en ce que la première pièce et la seconde pièce du dispositif de protection sont associées à un dispositif reliant la structure métallique de chacune des pièces du boîtier de protection pour permettre une continuité électrique entre les deux pièces et assurer l'étanchéité électromagnétique du dispositif de protection lorsque le volet est refermé sur le cadre de protection, ce dispositif de continuité électrique se trouvant intégré à un des éléments d'un dispositif de contrôle des mouvements de l'articulation du volet de protection avec le cadre de protection.

Selon une particularité de réalisation, le dispositif de protection selon l'invention est caractérisé en ce que, la surface des pièces du boîtier étant revêtue d'un élément de couverture non conducteur, le dispositif de continuité électrique traverse le revêtement pour être en contact avec la structure métallique de chacune des pièces du boîtier.

Selon une autre particularité de réalisation, le dispositif de protection selon l'invention est caractérisé en ce qu'au moins un des éléments de continuité électrique destiné à être monté et/ou fixé dans un logement du cadre de protection est collé et/ou clipsé avec au moins une colle conductrice.

Selon une première variante de réalisation, le dispositif de protection selon l'invention est caractérisé en ce qu'un dispositif de contrôle des mouvements de l'articulation entre le cadre de protection et le volet de protection comprend au moins un élément métallique inséré dans un logement du cadre de protection et dépassant de ce logement pour être en contact avec le volet de protection lorsque le volet de protection est en position fermée.

Selon une particularité de cette première variante de réalisation, le dispositif de protection selon l'invention est caractérisé en ce que, le volet de protection comporte au moins un logement sur sa face orientée vers le cadre de protection de sorte que ce logement est arrangé pour recevoir la portion de l'élément métallique qui dépasse du logement du cadre correspondant.

Selon une seconde variante de réalisation, le dispositif de protection selon l'invention est caractérisé en ce qu'un dispositif de contrôle des mouvements de l'articulation entre le cadre de protection et le volet de protection comprend au moins une paire d'aimants de stabilisation du volet de protection dans une position ouverte ou fermée par rapport à l'accès à l'intérieur du cadre de protection, caractérisé en ce que la continuité électrique est opérée par le contact d'un premier aimant d'une part monté sur le cadre de protection et d'autre part en contact avec la structure métallique du cadre de protection avec un second aimant monté fixé sur le volet de protection et en contact avec la structure métallique du volet.

Selon une particularité de cette seconde variante de réalisation, le dispositif de protection selon l'invention est caractérisé en ce que, le cadre de protection et le volet de protection intègre chacun au moins un aimant de stabilisation du volet de protection dans une position ouverte ou fermé par rapport au cadre de protection.

Selon une autre particularité de cette seconde variante de réalisation, le dispositif de protection selon l'invention est caractérisé en ce qu'au moins un aimant de stabilisation est positionné dans un logement disposé dans une des pièces du boîtier, une première partie de l'aimant étant en contact avec un second aimant monté fixé sur l'autre pièce du boîtier, tandis qu'une seconde partie de l'aimant est en contact avec une pièce de liaison également en contact avec la structure métallique.

Selon une autre particularité de cette seconde variante de réalisation, le dispositif de protection selon l'invention est caractérisé en ce que, un premier aimant du volet étant disposé en face d'un aimant de même polarité solidaire du cadre lorsque le volet est en position ouverte ou en position fermée, un aimant de polarité inverse de celle de l'aimant du volet est disposé au moins entre les deux aimants du cadre définissant les deux positions ouvertes et fermées

Selon une autre particularité de cette seconde variante de réalisation, le dispositif de protection selon l'invention est caractérisé en ce que les aimants sont recouverts d'un revêtement conducteur pour améliorer la continuité électrique entre les aimants et/ou entre chacun des aimants avec la structure métallique de la pièce respective du boîtier avec laquelle l'aimant est en contact.

Selon une autre particularité de cette seconde variante de réalisation, le dispositif de protection selon l'invention est caractérisé en ce que le revêtement conducteur est à base de chrome et/ou de nickel.

Selon une particularité de réalisation, le dispositif de protection selon l'invention est caractérisé en ce que le volet de protection s'articule avec le cadre de protection au niveau d'un axe de pivotement.

Selon une première alternative de réalisation de cette particularité, le dispositif de protection selon l'invention est caractérisé en ce que l'axe de pivotement est positionné selon une direction perpendiculaire au plan du volet de protection, de sorte que le pivotement soit parallèle au plan du volet de protection et au plan du cadre de protection, le volet de protection pivote sur le cadre de protection d'une position ouverte vers une position fermée dans un même plan.

Selon une autre alternative de réalisation de cette particularité, le dispositif de protection selon l'invention est caractérisé en ce que l'axe de rotation est positionné selon un axe parallèle au plan du volet de protection, de sorte que la rotation du volet de protection s'effectue autour dudit axe de rotation, le volet de protection tournant d'une position ouverte à une position fermée où il est rabattu vers le cadre de protection.

Selon une troisième variante de réalisation, le dispositif de protection selon l'invention est caractérisé en ce que en ce que le volet de protection est monté sur le cadre de protection pour se translater axialement depuis une position ouverte vers une position fermée.

D'autres particularités et avantages de la présente invention apparaîtront plus clairement à la lecture de la description ci-après, faite en référence aux dessins annexés, dans lesquels :

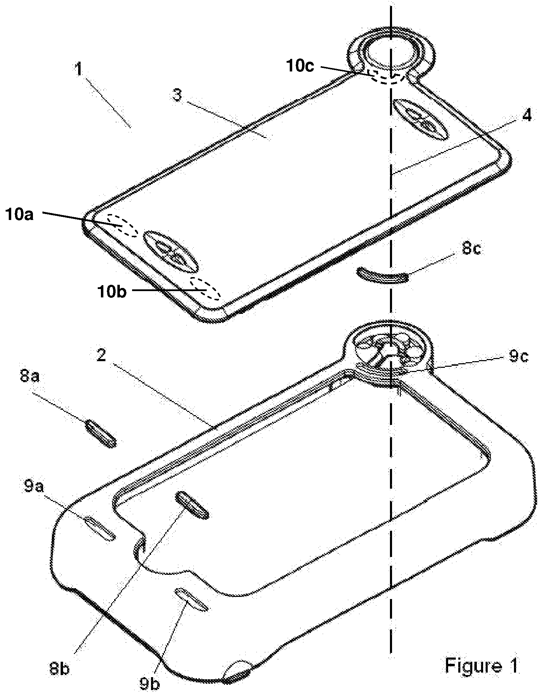

- la figure 1 représente une vue en perspective du boîtier de protection de l'invention selon un premier mode de réalisation particulier,

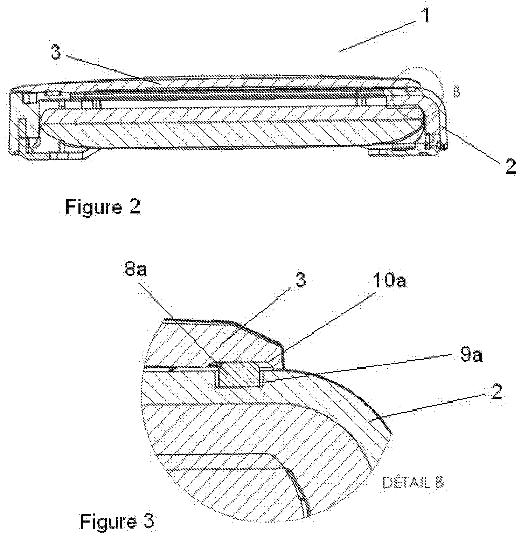

- la figure 2 représente une vue d'une première partie du dispositif de continuité électrique dans le premier mode de réalisation particulier,
- la figure 3 représente un détail du dispositif de continuité électrique selon la figure 2,

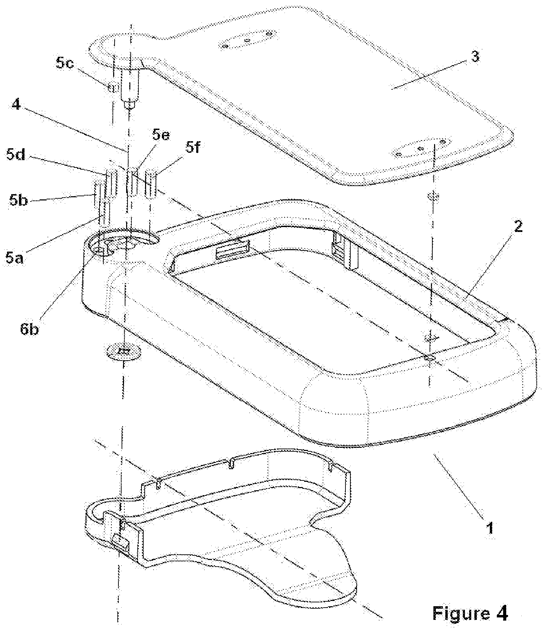

- la figure 4 représente une vue en perspective du boîtier de protection de l'invention selon un second mode de réalisation particulier,

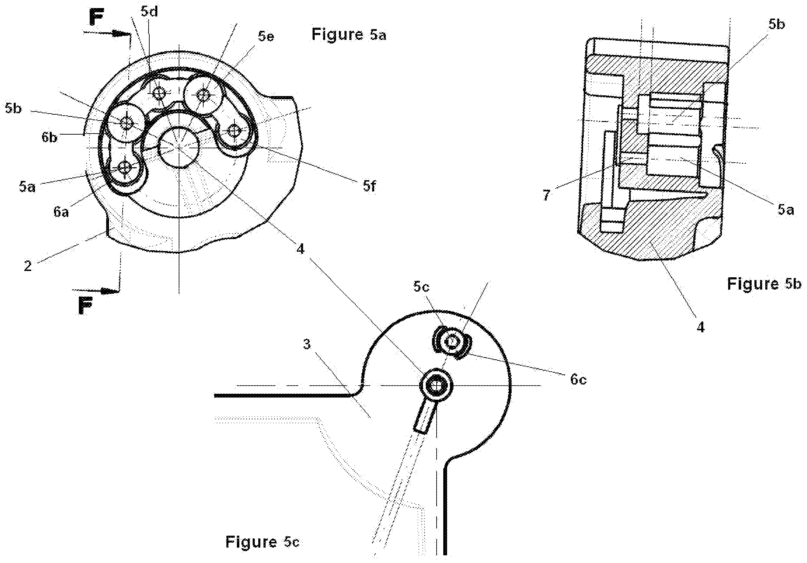

- la figure 5a représente une vue d'une première partie du dispositif de continuité électrique dans le second mode de réalisation particulier selon l'axe de pivotement du volet par rapport au cadre de protection,
- la figure 5b représente une vue de la première partie du dispositif de continuité électrique dans le second mode de réalisation particulier selon une coupe axiale F-F,
- la figure 5c représente une vue d'une seconde partie du dispositif de continuité électrique dans le second mode de réalisation particulier.

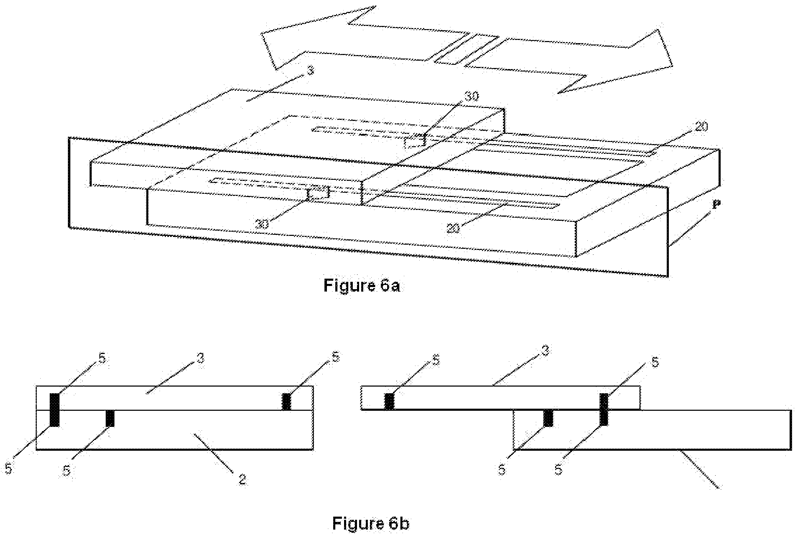

- la figure 6a représente une vue du dispositif dans un 3^{è} mode de réalisation,
- la figure 6b représente une vue en coupe selon le plan P.

Il convient de noter que l'utilisation du terme « terminal » désigne tout type de terminal susceptible d'être utilisé avec le dispositif de l'invention. Cependant dans la description suivante, le terme « terminal » renvoie préférentiellement à un appareil de téléphonie mobile.

La présente invention concerne un dispositif permettant à un boîtier (1) de protection destiné à recevoir un terminal et dont au moins une des faces, préférentiellement la face se positionnant entre le terminal et l'oreille ou la joue de l'utilisateur, est formé par un cadre (2) de protection destiné à être recouvert par un volet (3) de protection. Le boîtier de protection (1) peut également présenter une ou plusieurs faces, autres que les faces de protection, ouvertes pour des raisons techniques ou esthétiques.

En effet, pour pouvoir fonctionner correctement en dépit de son rôle de protection grâce à son étanchéité aux ondes électromagnétiques, le boîtier de protection (1) ne doit pas recouvrir entièrement le téléphone mobile car cela rendrait impossible tout protocole de communication nécessitant l'émission, et/ou la réception, par le téléphone mobile d'ondes électromagnétiques vers, et/ou de, l'extérieur, respectivement. C'est pourquoi le boîtier de protection (1) doit être ouvert. Cette caractéristique de l'élément de protection (1) rend sa conception plus facile et son adaptation plus large. En effet, ne formant pas un élément fermé, mais ouvert, les dimensions de l'élément de protection (1) ne sont pas contraintes par les dimensions ou la forme du dos (22) du téléphone mobile (2).

Le boîtier de protection (1) constitue pour l'utilisateur un blindage contre les ondes électromagnétiques émises par son téléphone mobile. Cette caractéristique d'étanchéité aux ondes électromagnétiques ne peut être remplie que par un matériau dont la conductivité électrique est optimale, comme par exemple et de façon non-limitative le cuivre.

Si de plus, le boîtier de protection (1) présente une concavité orientée vers le demi-espace où est positionné le terminal, alors les ondes électromagnétiques émises par le terminal sont non seulement réfléchies par la paroi de protection du boîtier (1) dans tout le demi-espace de droite, mais également émises vers ce demi-espace, préférentiellement selon une direction normale par rapport au plan défini par l'élément de protection (1), c'est-à-dire dans la direction opposée à l'utilisateur. Cette forme concave peut donc également rendre l'élément de protection (1) plus efficace que s'il formait une simple surface plane finie.

Toutefois, il convient de noter que l'objectif de protection du dispositif de la présente invention ne peut être atteint que sous certaines conditions.

La concavité du boîtier de protection (1) doit être suffisamment ouverte et/ou suffisamment profonde pour éviter le retour des ondes électromagnétiques vers l'utilisateur par des effets de bords le long du pourtour du boîtier de protection (1). C'est pourquoi la section curviligne du cadre (2) de protection doit avoir un rayon de courbure supérieure à la profondeur de l'élément de protection (1) et/ou la profondeur de l'élément de protection doit être supérieure à l'épaisseur du téléphone mobile. Pour une raison similaire, le boitier de protection (1) doit se trouver en vis à vis d'au moins un tiers de l'épaisseur du pourtour du terminal mobile. Ainsi, la dimension en profondeur de l'élément de protection (1) se doit d'être supérieure au tiers de l'épaisseur du pourtour du terminal mobile.

Le boîtier de protection (1) est constitué au moins en partie en matériau métallique bon conducteur, comme le sont les antennes émettrices/réceptrices d'ondes électromagnétiques, or il faut s'assurer que l'élément de protection (1) ne fonctionne pas pour l'utilisateur comme une antenne mais bel et bien comme une protection. Pour cela, le boîtier de protection (1) ne doit pas capter et amplifier les rayonnements électromagnétiques émis par le terminal mobile. C'est pourquoi, il est alors nécessaire d'isoler électriquement le terminal mobile du boîtier de protection (1), ou plus particulièrement des parties en matériau métallique de l'élément de protection qui présentent une bonne conductivité électrique. Cette isolation électrique est réalisée et assurée par le maintien d'un espace d'au moins 2 mm, de toute part, entre l'interface ergonomique du terminal mobile et les parties métalliques du boîtier de protection (1). Il convient de noter que, pour un espace entre l'interface ergonomique du terminal mobile et les parties métalliques de l'élément de protection de 0.5 mm par exemple, les parties métalliques du boîtier de protection conduisent, voire amplifient, les ondes électromagnétiques émises et/ou reçues par le terminal mobile. On peut également préciser une borne supérieure des valeurs possibles pour l'espace électriquement isolant entre l'interface ergonomique du terminal mobile et les parties métalliques du boîtier de protection (1). Cette borne supérieure est fixée à 10 mm, ce choix étant uniquement dicté par le souhait de conserver un ensemble, formé du terminal mobile et de son élément de protection, qui soit mobile et d'une taille et d'un esthétisme convenables. Préférentiellement, l'espace électriquement isolant entre le terminal mobile et le boîtier de protection (1) est de toute part d'une valeur comprise entre 3 et 8 mm.

En conséquence, les dimensions en longueur et en largeur du boîtier de protection (1) doivent être supérieures aux dimensions en longueur et en largeur du terminal mobile. En conséquence également, la dimension en profondeur du boîtier de protection (1) doit être au moins égale au tiers de l'épaisseur du pourtour du terminal mobile additionnée de l'espace électriquement isolant entre l'interface ergonomique du terminal mobile et les parties métalliques du boîtier de protection situé en vis-à-vis de ladite interface ergonomique.

Dans le cas d'une métallisation continue ou discontinue sur un substrat électriquement isolant d'une épaisseur déterminée, l'espace électriquement isolant entre l'interface ergonomique du terminal mobile et les parties métalliques du boîtier de protection correspond à l'espace entre l'interface ergonomique du terminal mobile et le substrat, plus l'épaisseur déterminée du substrat.

Le choix d'un boîtier de protection plus ou moins ouvert et/ou plus ou moins profond et le choix d'un espace électriquement isolant entre l'interface ergonomique du terminal mobile et les parties métalliques du boîtier de protection (1) d'une valeur particulière, d'au moins 2 mm, sont préférentiellement dépendants l'un de l'autre. De nombreux tests scientifiques de performance de protection de l'élément de protection ont été effectués desquels il ressort que les deux conditions primordiales ci-dessus énoncées sont liées entre elles relativement aux capacités fonctionnelles de base d'émission/réception du téléphone mobile. Premièrement, pour un terminal mobile et un boîtier de protection (1) de forme et de dimensions fixées, il peut résulter d'un espace faible entre eux, par exemple inférieur ou égal à 2 mm, un disfonctionnement et/ou une perte de performance significative du terminal mobile quant à ces capacités fonctionnelles de base d'émission/réception, cet inconvénient étant largement estompé dès lors que l'espace électriquement isolant atteint une valeur d'au moins 3 mm. Deuxièmement, pour un même espace électriquement isolant entre le terminal mobile et l'élément de protection, plus l'élément de protection est profond relativement à l'épaisseur du terminal mobile, plus le disfonctionnement et la perte de performance du terminal mobile sont significatifs. Du fait que le terminal mobile délivre des signaux d'une plus grande puissance afin de conserver la qualité des transmissions, une surchauffe et/ou un déchargement prématuré de sa batterie, ou plus généralement une réduction de son autonomie, peuvent alors être observés. La qualité de la protection contre les ondes électromagnétiques émises par le terminal mobile est, quant à elle, faiblement affectée par la variation de ces paramètres et reste satisfaisante dans les limites définies dans la présente demande.

Le choix d'un élément de protection suffisamment ouvert et/ou suffisamment profond et le choix d'une valeur d'au moins 2 mm, préférentiellement comprise entre 3 et 8 mm, pour l'espace électriquement isolant entre l'interface ergonomique du terminal mobile et les parties métalliques du boîtier de protection doit donc correspondre à la recherche d'un compromis entre la qualité de la protection apportée et la qualité des communications à partir du terminal. De plus, le souhait de conserver un ensemble, terminal mobile et élément de protection, mobile et esthétique impose un encombrement minimum. C'est à cette fin qu'il est précisé un espace électriquement isolant de 10 mm maximum, préférentiellement de 8 mm maximum.

Les fourchettes de valeurs suivantes sont précisées et données à titre d'exemple non limitatif. La longueur du boitier de protection est égale ou supérieure à 1,15 fois la longueur du terminal mobile, la largeur du boîtier de protection est égale ou supérieure à 1,2 fois la largeur du terminal mobile, et la profondeur du boitier de protection est égale ou supérieure à 1,3 fois l'épaisseur du terminal mobile. La longueur du boitier de protection est inférieure ou égale à 1,3 fois la longueur du terminal mobile, la largeur du boitier de protection est inférieure ou à gale à 1,3 fois la largeur du terminal mobile et la profondeur du boitier de protection est inférieure ou égale à 1,6 fois l'épaisseur du terminal mobile. Les dimensions du boitier de protection relativement aux dimensions du terminal mobile sont à définir au cas par cas dans les fourchettes de valeurs mentionnées, afin d'optimiser la protection apportée, tout en minimisant l'encombrement de l'élément de protection et la relative dégradation des performances du terminal mobile liée à son utilisation avec le boitier de protection.

Du fait de son étanchéité aux ondes électromagnétiques, le boitier de protection (1) ne doit pas recouvrir entièrement le terminal mobile (2) car cela rendrait impossible tout protocole de communication nécessitant l'émission, et/ou la réception, par le terminal mobile d'ondes électromagnétiques vers, et/ou de, l'extérieur, respectivement. C'est pourquoi le boitier de protection (1) est ouvert et le fond de la concavité est disposé en vis-à-vis de l'interface ergonomique du terminal mobile.

Cette caractéristique du boîtier de protection (1) rend sa conception plus facile et son adaptation plus large. En effet, ne formant pas une boîte fermée, mais un réceptacle ouvert, le boîtier de protection (1) est contraint en dimension et en forme par les dimensions et la forme de la face du terminal mobile comprenant l'interface ergonomique et du pourtour de l'épaisseur du terminal mobile, mais n'est pas contraint par les dimensions ou la forme de la face du terminal mobile opposée à l'interface ergonomique.

Il convient de noter que le boîtier de protection (1) peut comporter, au niveau de sa face de protection, un ou plusieurs orifices de taille caractéristique inférieure aux différentes longueurs d'onde des ondes électromagnétiques des différentes normes de terminaux mobile, par exemple inférieure à 1 cm, les orifices étant situés en vis à vis du haut-parleur ou du microphone du terminal mobile ou en face des connectiques de téléphone mobile. Imposer une limite supérieure à la taille caractéristique des orifices assure que ceux-ci n'altèrent pas la qualité de la protection aux ondes électromagnétiques de l'élément de protection (1). Par exemple, à une onde électromagnétique de fréquence 30 GHz est associée une longueur d'onde de 1 cm, or les terminaux mobiles émettent des ondes électromagnétiques d'une fréquence d'environ 1 GHz correspondant à une longueur d'onde de 30 cm environ. Des orifices sont situés en vis à vis du haut-parleur et du microphone du terminal mobile ou plus généralement de tout dispositif du terminal mobile émettant ou recevant des ondes acoustiques. Cette disposition des orifices (3a) est souhaitée pour prévenir et éviter toute altération de la qualité de la transmission des ondes acoustiques entre l'utilisateur et le terminal mobile.

La structure métallique qui participe à la paroi de protection est composée en partie d'un réseau maillé métallique présentant une conductivité électrique optimale. Selon un mode de réalisation préféré mais non limitatif, ce réseau maillé métallique a un pas de grille régulier de 10mm sur 10mm et ses lignes conductrices ont une largeur de 0.5mm. Un tel réseau maillé métallique constitue un blindage contre les ondes électromagnétiques de fréquences inférieures à 3 GHz, or les ondes électromagnétiques émises par les téléphones mobiles sont d'environ 1 GHz, ce qui correspond à une longueur d'onde *λ* de 30cm ; des ouvertures de l'ordre de *λ*/30 sont permises sans altérer les effets recherchés. Par conséquent, ce mode de réalisation de la structure métallique de la paroi de protection (1) constitue un blindage plus qu'efficace sur une bande de fréquence des ondes électromagnétiques plus large que celle utilisée par la plupart des téléphones mobiles actuellement sur le marché.

Ce réseau maillé métallique est toutefois fragile et l'invention propose pour assurer la longévité de cette protection de l'incorporer dans, ou de l'imprimer par sérigraphie sur, un support plus robuste comme une membrane ou de l'intercaler dans une grille de trame plus fine.

La face du boîtier de protection (1) étanche à l'encontre des ondes électromagnétiques comporte au moins un cadre (2) et un volet (3) de dimensions en longueur et en largeur suffisantes pour couvrir au moins le périmètre interne du cadre (2). Le volet (3) et le cadre (2) sont agencées pour assurer une continuité électrique entre elles, au moins lorsque le volet (3) recouvre le cadre (2). Cette continuité électrique entre la partie métallique du cadre (2) et la partie métallique du volet (3) permet aux parties métalliques du volet (3) et du cadre (2) de former une face du boîtier de protection (1) étanche aux ondes électromagnétiques, lorsque le volet (3) recouvre le cadre (2).

Dans un souci de réduction du nombre de pièces à usiner et à monter, la continuité électrique entre les parties métalliques du cadre (2) et du volet (3) est opérée grâce à dispositif de continuité électrique associé à l'articulation entre le cadre (2) et le volet (3) en faisant intervenir une ou plusieurs pièces de contrôle de cette articulation.

Selon un premier mode de réalisation représenté sur les différentes figures, le volet (3) et le cadre (2) sont liés, par un de leurs coins, par une liaison pivot dont l'axe est perpendiculaire au plan du volet (3) et du cadre (2). La liaison pivot doit permettre le pivotement du volet (3) par rapport au cadre (3), au moins dans un sens et entre deux positions. Ces deux positions consistent en une position de recouvrement du cadre par le volet et au moins une position de non-recouvrement du cadre par du volet. Par exemple, deux sens de pivotement et trois positions du volet par rapport au cadre sont envisageables : une première position de recouvrement du cadre par le volet, une seconde position de non-recouvrement du cadre par le volet par un pivotement du volet à gauche du cadre et une troisième position de non-recouvrement du cadre par le volet par un pivotement du volet à droite du cadre.

De façon générale, l'idée est de permettre à l'utilisateur de se protéger des ondes électromagnétiques émises par son terminal ou téléphone mobile quand il le souhaite, sans perdre l'usage de l'interface ergonomique de son téléphone mobile. Ainsi, il est préféré que la position de non-recouvrement du cadre (2) par le volet (3) libère entièrement l'accès à l'interface ergonomique du terminal.

La continuité électrique entre ces deux parties métalliques du cadre et de l'écran est assurée grâce à un dispositif intégré dans un des éléments de contrôle de l'articulation du volet (3) de protection par rapport au cadre (2) de protection. Cette intégration de la continuité dans des éléments de contrôle déjà présents dans le boîtier a comme avantage de pouvoir proposer le dispositif de l'invention sans que celui-ci n'impose un usinage de pièces supplémentaires. Par ailleurs, en intégrant le dispositif de continuité électrique dans des éléments de contrôle de l'articulation, les surfaces respectives du cadre (2) et du volet (3) sont en mesure d'être recouvertes par un revêtement non-conducteur, par exemple pour une finalité esthétique.

Bien que la continuité électrique entre les deux pièces (2, 3) du boîtier (1) puisse exister à la fois lorsque le volet (3) est en position ouverte et en position fermée par rapport au cadre (2) de protection, il est important que cette continuité électrique existe au moins lorsque le volet (3) de protection est rabattu sur le cadre (2) de protection pour l'obstruer.

Dans des premiers modes de réalisation, les éléments de contrôle, voire de blocage, de l'articulation du volet (3) dans une position fermée et/ou une position ouverte, sont réalisés par un ou plusieurs éléments métalliques (8a, 8b, 8c) disposés stratégiquement sur la structure des éléments du boîtier (1) de protection. Ces éléments métalliques (8a, 8b, 8c) sont positionnés dans des logements (9a, 9b, 9c) réalisés sur la surface du cadre (2) qui fait face au volet (3) de protection. Ces éléments métalliques (8a, 8b, 8c) présentent une épaisseur plus importante que la profondeur de leurs logements de sorte que leur partie supérieure dépasse du logement pour interagir avec un logement (10a, 10b, 10c) porté par le volet (3) de protection et qui fait face au cadre (2) de protection. Lorsque le volet (3) de protection est en position fermé, le logement (10a, 10b, 10c) qu'il porte se trouve positionné en regard du logement (9a, 9b, 9c) porté par le cadre (2).

Selon un mode de réalisation préféré, l'élément métallique (8a, 8b, 8c) est fixé dans le logement (9a, 9b, 9c) sur le cadre (2) et entre en contact avec le logement (10a, 10b, 10c) porté par le volet (3) de protection. Toutefois, dans une variante de réalisation, l'élément métallique peut également être fixé sur le volet (3) de protection et venir en contact avec le logement (9a, 9b, 9c) porté par le cadre (2). L'élément métallique (8a, 8b, 8c) participe ainsi à la continuité électrique entre les deux pièces, cadre (2) et volet (3). Bien que l'élément mécanique soit préférentiellement " clipsé " ou encliqueté dans son logement, la continuité électrique peut également être assurée par l'utilisation d'une colle conductrice qui fixe l'élément métallique dans son logement.

Au-delà de l'intérêt de la continuité électrique, les éléments métalliques peuvent également former des éléments de contrôle des mouvements de l'articulation du volet de protection avec le cadre de protection en bloquant le volet dans la position fermée. Ce blocage est opéré grâce au positionnement de la partie supérieure de l'élément métallique qui dépasse du logement du cadre pour se positionner dans le logement porté par le volet (3) de protection. Lorsque le volet (3) est en position ouverte, les éléments métalliques forment ainsi des ergots par rapport à la surface du cadre. Lorsque le volet est rabattu en position fermée, la surface du volet glisse contre ces ergots formés par les éléments métalliques jusqu'à ce que ses logements se positionnent sur ces ergots métalliques portés par le cadre (2). Lorsque les logements portés par le volet de protection et par le cadre se font face avec l'élément métallique correspondant positionné dans ces logements, le volet demeure maintenu en position fermée, bloqué par l'élément métallique fixé au cadre qui fait saillie dans le logement porté par le volet. Toutefois, les bords du logement porté par le volet comportent des rampes dont la forme est adaptée d'une part pour y retenir la partie de l'élément métallique qui s'y trouve et empêcher le déplacement du volet, et d'autre part pour permettre y permettre un coulissement de l'ergot de l'élément métallique lorsqu'un utilisateur exerce une pression latérale minimum sur le volet pour en permettre le déplacement.

Selon une particularité de réalisation, ces éléments métalliques sont arrangés de façon à présenter une forme en longueur. Selon un positionnement particulier, la longueur de ces éléments métalliques est positionnée de façon à être orientée selon un axe passant par une tangente d'un cercle centré sur l'axe (4) de pivotement du volet (3) par rapport au cadre (2) et dont le rayon est égal à la distance qui sépare la position de l'élément métallique de cet axe (4) de pivotement.

Selon une variante de cette particularité, l'élément métallique (8a, 8b, 8c) présente une longueur courbe qui peut, par exemple, être orientée selon une portion du périmètre d'un cercle sensiblement centré sur l'axe de pivotement (4) du volet (3).

Dans d'autres modes de réalisation, les éléments de contrôle, voire de blocage, de l'articulation du volet (3) dans une position fermée et/ou une position ouverte, sont réalisés par des aimants (5a, 5b, 5c) disposés stratégiquement sur la structure des éléments du boîtier (1) de protection pour pouvoir interagir entre eux. Ainsi selon un mode de réalisation non-limitatif, les éléments de contrôle comportent trois aimants (5a, 5b, 5c). Un premier aimant (5c) est monté-fixé sur une face du volet (3) tandis que les deux autres aimants (5a, 5b) sont montés-fixés sur le cadre (2) de façon à être respectivement positionné en regard du premier aimant (5c) et interagir avec celui-ci par attraction lorsque le volet (3) est déplacé pour être en position respectivement ouverte ou fermée.

Chacun des aimants (5a, 5b, 5c) est respectivement monté-fixé au cadre (2) et au volet (3) du boîtier (1) de protection de façon à être en contact avec la surface métallique de la structure (2, 3) respective qui les supporte. Les aimants (5a, 5b, 5c) forment ainsi le dispositif de continuité électrique entre le cadre (2) et le volet (3).

Afin que la continuité électrique opérée par les aimants (5a, 5b, 5c) soit optimale, ceux-ci sont recouverts d'un revêtement à base de nickel et/ou de chrome.

Selon un mode de réalisation particulier, la fixation des aimants (5a, 5b, 5c) sur leurs surfaces respectives du volet (3) et du cadre (2) est effectuée à partir d'une colle magnétique.

Dans l'exemple de réalisation particulier représenté sur les figures, les aimants (5a, 5b, 5c) sont positionnés dans des logements (6a, 6b, 6c) agencés dans l'épaisseur de la pièce qui les supporte respectivement.

Selon une particularité, un ou plusieurs des logements (6a, 6b, 6c) destiné à recevoir des aimants comprennent un alésage dans lequel est positionné une pièce de liaison (7), conductrice, qui assure la connexion électrique entre une face de l'aimant (5a, 5b, 5c) et la structure métallique de l'élément de support qui porte l'aimant. Une seconde face de l'aimant (5a, 5b, 5c) est alors destinée à être en contact avec la surface de l'aimant monté sur l'autre pièce du boîtier (1) de protection. Par exemple, et de façon non-limitative, lorsque l'aimant présente une forme de cylindre, l'aimant positionné dans son logement a d'une part une première partie positionnée à l'extérieure du logement pour interagir avec la surface de l'aimant monté sur l'autre pièce du boîtier (1) de protection, et d'autre part une seconde partie positionnée dans le logement au niveau d'un orifice de l'alésage, en contact avec la pièce de liaison (7) qui est elle-même en contact avec la structure métallique de l'élément du boîtier (1) de protection qui porte l'aimant.

Selon un premier mode de réalisation, l'articulation du volet (3) sur le cadre (2) du boîtier de protection est opérée par pivotement au niveau d'un axe (4) orienté perpendiculairement par rapport au plan du volet (3) et du cadre (2). Cet axe de pivotement est par exemple positionné à proximité ou au niveau d'un angle du cadre (2). Sur le cadre, à la périphérie du pivot, se trouve positionnés les différents logements (6a, 6b) destinés à recevoir les aimants de contrôle/blocage de l'articulation. Ces logements (6a, 6b) fixés à proximité de l'axe (4) de pivotement sont excentrés par rapport à cet axe. Les logements (6a, 6b) de ces aimants (5a, 5b) sont agencés pour que l'aimant (6c) logé dans le volet (3) passe en vis-à-vis de l'aimant logé dans chaque alésage du cadre (3) sur le trajet de pivotement de l'écran (4) par rapport au cadre. Par exemple, l'aimant (5c) logé dans le logement (7c) du volet (3) est agencé pour interagir par attraction avec un premier aimant (5a) logé dans un premier logement (6a) du cadre (2), et maintenir le volet (3) en positon de recouvrement du cadre (2). De cette façon, une première indexation du pivotement du volet (3) par rapport au cadre (2) correspond à la position de recouvrement du cadre (2) par le volet (3). De plus, l'aimant (5c) fixé au volet (3) est également positionné pour être attiré par un second aimant (5b) logé dans un second logement (6b) du cadre (2) et maintenir le volet (3) en position de non-recouvrement du cadre (2).

Dans une particularité de réalisation présentée sur les figures, le cadre (2) comprend un troisième aimant (5d) logé dans un troisième logement (6d) positionné entre le premier (6a) et second logement (6b). Cependant, contrairement au deux autres aimants (5a, 5b) montés-fixés sur le cadre (2), ce troisième aimant (5d) est agencé pour repousser l'aimant (5c) monté sur le volet (3). De cette façon, le volet (3) se trouvant dans une position intermédiaire entre la position de recouvrement et la position de non-recouvrement du cadre (2) se trouve à la fois repousser par le troisième aimant (5c) et attiré par l'aimant le plus proche entre le premier (5a) et le second aimants (5b) pour basculer vers l'une ou l'autre des positions de recouvrement ou de non-recouvrement du cadre (2). Lorsque l'aimant (5c) monté-fixé au volet (2) coulisse pour passer d'une position d'attraction en contact avec le première aimant (5a) vers le deuxième aimant (5b), son passage en répulsion contre le troisième aimant (5d) n'a pas besoin de s'effectuer par contact pour garantir une continuité électrique, d'une part parce que la répulsion formé par ces aimants (5d, 5c) s'oppose à ce contact et d'autre part parce que ce positionnement est uniquement ponctuelle lorsque le volet (3) passe d'une position de recouvrement du cadre (2) à une position de non-recouvrement.

Selon une alternative de réalisation, le pivotement du volet (3) par rapport au cadre (2) du boîtier de protection peut être réalisé dans deux directions, chacune des directions étant orientée de part et d'autre de la position de recouvrement du cadre (2) par le volet (3). Ainsi le volet (3) présente deux positions de non-recouvrement arrangées par un pivotement de part et d'autre de sa position de recouvrement. Le contrôle et le blocage du volet (3) dans des positions de non-recouvrement de part et d'autre de la position de recouvrement est obtenu grâce à l'utilisation d'un quatrième (5e) et d'un cinquième aimant (5f) montés-fixés sur le cadre (2). Ces quatrième (5e) et cinquième aimants (5f) sont positionnés de telles sorte que l'aimant monté-fixé sur le volet (3) soit repoussé par le quatrième aimant du cadre (2) vers les troisième (5d) et cinquième aimants (5f) montés attractifs. Ainsi, le troisième aimant (5d) participe au blocage du volet (3) dans une position recouvrement du cadre, tandis que les premier (5a) et cinquième aimants (5f) du cadre (2) participe au blocage du volet (3) dans une position de non-recouvrement.

Selon un second mode de réalisation, l'articulation du volet (3) sur le cadre (2) du boîtier de protection (1) est opérée par pivotement ou par rotation au niveau d'un axe (4) orienté parallèlement par rapport au plan du volet (3) et du cadre (2). Cet axe de pivotement est, par exemple, positionné à proximité ou au niveau d'un bord du cadre (2) de protection. Le dispositif pour le contrôle/blocage de l'articulation de positionnement du volet (3) sur le cadre (2) est également opéré selon un dispositif à aimants tel que celui précédemment décrit. Toutefois, la variante de réalisation faisant intervenir trois aimants montés-fixés sur le cadre (2) du boîtier de protection (1) est préférée à l'alternative comportant cinq aimants puisqu'à partir de la position de recouvrement du volet (3) sur le cadre (2), le volet (3) n'est en mesure de se déplacer que dans une seule direction de pivotement pour atteindre une position de non-recouvrement.

Selon un troisième mode de réalisation, le volet (3) de protection est monté coulissant axialement dans son propre plan en glissant sur la surface du cadre (2). Selon un exemple de réalisation non-limitatif, l'axe de glissement du volet (3) est défini par un ou plusieurs rails positionnés sur le cadre (2) du dispositif. Ces rails peuvent être formés par exemple par des rainures (20) sur le cadre (2) dans lesquelles coulissent des ergots (30) portés par le volet (3) et montés sur la face du volet (3) positionnée en vis-à-vis du cadre (2) de protection. Les moyens de contrôle/blocage de l'articulation du volet (3) sur le cadre sont également formés par des aimants (5) qui interagissent au moins de façon attractive dans les positions de recouvrement ou de non-recouvrement du cadre (2) par le volet (3). Ces aimants (5) participent ainsi au dispositif de continuité électrique entre les structures métalliques du volet (3) et du cadre (2) selon un mode opératoire similaire à celui décrit pour les autres modes de réalisation.

Dans ce mode de réalisation, le contrôle du coulissement du volet (3) sur le cadre (2) entre une position de recouvrement et une position de non-recouvrement peut être obtenue par soit en utilisant un même aimant (5) monté-fixé, par exemple sur le volet (3), et destiné à interagir avec une paire d'aimants montés-fixés sur le cadre (2). L'aimant (5) du volet (3) interagit ainsi alternativement avec un premier aimant (5) du cadre (2) lorsque le volet est position de recouvrement et avec un second aimant (5) du cadre (2) lorsque le volet est en position de non-recouvrement. Selon une variante de réalisation, le volet (3) comprend deux aimants (5) espacé d'une longueur différente de celle qui sépare les deux aimants montés-fixés sur le cadre (2). Cet arrangement fait en sorte qu'alternativement, une première paire d'aimants (5), l'un fixé au volet et l'autre au cadre, est connectée lorsque le volet est position de recouvrement et une seconde paire d'aimants (5) l'un également fixé au volet et l'autre au cadre, est connectée lorsque le volet est position de non-recouvrement.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Dispositif de protection contre des ondes électromagnétiques émises par un terminal mobile formant un boîtier (1) comportant au moins une face de protection métallique adapté pour entourer le terminal et ce boîtier comprenant au moins une première pièce arrangée pour définir un cadre métallique (2) de protection destiné à recevoir le terminal et une seconde pièce qui forme un volet de protection (3) amovible s'articulant avec le cadre de la première partie pour rendre étanche au moins une face de protection du boitier de protection (1), **caractérisé en ce que** la première pièce (2) et la seconde pièce (3) du dispositif de protection sont associées à un dispositif reliant la structure métallique de chacune des pièces du boîtier de protection pour permettre une continuité électrique entre les deux pièces et assurer l'étanchéité électromagnétique du dispositif de protection lorsque le volet est refermé sur le cadre de protection, ce dispositif de continuité électrique se trouvant intégré à un des éléments d'un dispositif de contrôle des mouvements de l'articulation du volet de protection avec le cadre de protection.

2. Dispositif de protection selon la revendication 1, **caractérisé en ce que**, la surface des pièces du boîtier étant revêtue d'un élément de couverture non conducteur, le dispositif de continuité électrique traverse le revêtement pour être en contact avec la structure métallique conductrice de chacune des pièces du boîtier.

3. Dispositif de protection selon une des revendications 1 à 2, **caractérisé en ce qu'**au moins un des éléments de continuité électrique destiné à être monté et/ou fixé dans un logement (9a, 9b, 9c) du cadre de protection (2) est collé et/ou clipsé avec au moins une colle conductrice.

4. Dispositif de protection selon une des revendications 1 à 3, **caractérisé en ce qu'**un dispositif de contrôle des mouvements de l'articulation entre le cadre de protection et le volet de protection comprend au moins un élément métallique (8a, 8b, 8c) inséré dans un logement du cadre de protection (2) au contact de la couche métallisée et dépassant de ce logement pour être en contact avec la couche conductrice du volet de protection lorsque le volet de protection est en position fermée.

5. Dispositif de protection selon la revendication 4, **caractérisé en ce que**, le volet de protection (3) comporte au moins un logement (10a, 10b, 10c) sur sa face orientée vers le cadre de protection de sorte que ce logement est arrangé pour recevoir la portion de l'élément métallique qui dépasse du logement du cadre correspondant.

6. Dispositif de protection selon une des revendications 1 à 3, **caractérisé en ce qu'**un dispositif de contrôle des mouvements de l'articulation entre le cadre de protection (2) et le volet de protection (3) comprend au moins une paire d'aimants (5a, 5b, 5c, 5d, 5e, 5f) de stabilisation du volet de protection dans une position ouverte ou fermée par rapport à l'accès à l'intérieur du cadre de protection (2), **caractérisé en ce que** la continuité électrique est opérée par le contact d'un premier aimant d'une part monté sur le cadre de protection et d'autre part en contact avec la structure métallique du cadre de protection avec un second aimant monté fixé sur le volet de protection et en contact avec la structure métallique du volet.

7. Dispositif de protection selon la revendication 6, **caractérisé en ce que**, le cadre de protection (2) et le volet de protection (3) intègrent chacun au moins un aimant de stabilisation du volet de protection dans une position ouverte ou fermé par rapport au cadre de protection.

8. Dispositif de protection selon la revendication 6 ou 7, **caractérisé en ce qu'**au moins un aimant de stabilisation est positionné dans un logement (6a, 6b, 6c) disposé dans une des pièces du boîtier, une première partie de l'aimant étant en contact avec un second aimant monté fixé sur l'autre pièce du boîtier, tandis qu'une seconde partie de l'aimant est en contact avec une pièce de liaison également en contact avec la structure métallique.

9. Dispositif de protection selon une des revendications 6 à 8, **caractérisé en ce que**, un premier aimant du volet étant disposé en face d'un aimant de même polarité solidaire du cadre lorsque le volet (3) est en position ouverte ou en position fermée, un aimant de polarité inverse de celle de l'aimant du volet est disposé au moins entre les deux aimants du cadre définissant les deux positions ouvertes et fermées.

10. Dispositif de protection selon une des revendications 6 à 9, **caractérisé en ce que** les aimants (5) sont recouverts d'un revêtement conducteur pour améliorer la continuité électrique entre les aimants et/ou entre chacun des aimants avec la structure métallique de la pièce respective du boîtier avec laquelle l'aimant est en contact.

11. Dispositif de protection selon une des revendications 4 à 10, **caractérisé en ce que** le volet de protection s'articule avec le cadre de protection au niveau d'un axe de pivotement (4).

12. Dispositif de protection selon une des revendications 4 ou 5 et selon la revendication 11, **caractérisé en ce que** l'élément métallique présente au moins une longueur orientée selon une tangente à un cercle centré sur l'axe de pivotement du volet de protection avec le cadre (2).

13. Dispositif de protection selon une des revendications 11 ou 12, **caractérisé en ce que** l'axe de pivotement (4) est positionné selon une direction perpendiculaire au plan du volet de protection, de sorte que le pivotement soit parallèle au plan du volet de protection (3) et au plan du cadre de protection (2), le volet de protection pivote sur le cadre de protection d'une position ouverte vers une position fermée dans un même plan.

14. Dispositif de protection selon une des revendications 11 ou 12, **caractérisé en ce que** l'axe de rotation est positionné selon un axe parallèle au plan du volet de protection (3), de sorte que la rotation du volet de protection s'effectue autour dudit axe de rotation, le volet de protection tournant d'une position ouverte à une position fermée où il est rabattu contre le cadre de protection.

15. Dispositif de protection selon une des revendications 4 à 12, **caractérisé en ce que** le volet de protection (3) est monté sur le cadre de protection pour se translater axialement depuis une position ouverte vers une position fermée.

## Patentansprüche

1. Schutzvorrichtung gegen elektromagnetische Wellen, die von einem mobilen Endgerät emittiert werden und ein Gehäuse (1) bilden, das mindestens eine metallische Schutzfläche umfasst, die den Anschluss umgibt, wobei das Gehäuse mindestens ein erstes Teil umfasst, das einen metallischen Schutzrahmen (2) zur Aufnahme des Anschlusses definiert und ein zweites Teil, das eine abnehmbare Schutzklappe (3) bildet, die mit dem Rahmen des ersten Teils gelenkig verbunden ist, um mindestens eine Schutzfläche des Schutzgehäuses (1) abzudichten, **dadurch gekennzeichnet, dass** das erste Teilstück (2) und das zweite Teilstück (3) der Schutzvorrichtung mit einer Vorrichtung verbunden sind, die die Metallstruktur jedes der Teile des Schutzgehäuses verbindet, um eine elektrische Kontinuität zwischen den beiden Teilen zu ermöglichen und die elektromagnetische Abdichtung der Schutzvorrichtung sicherzustellen, wenn die Klappe an dem Schutzrahmen dieser Vorrichtung geschlossen ist, wobei die elektrische Kontinuitätsvorrichtung in eines der Elemente einer Vorrichtung zur Steuerung der Bewegungen des Scharniers der Schutzklappe mit dem Schutzrahmen eingebaut ist.

2. Schutzvorrichtung nach Anspruch 1, **dadurch gekennzeichnet, dass** die Oberfläche der Gehäuseteile mit einem nichtleitenden Abdeckelement beschichtet ist, wobei die elektrische Kontinuitätsvorrichtung die Beschichtung durchläuft, um mit jeder Elemente der leitfähigen Metallstruktur in Kontakt zu sein.

3. Schutzvorrichtung nach einem der Ansprüche 1 bis 2, **dadurch gekennzeichnet, dass** mindestens eines der elektrischen Anschlusselemente, die dazu bestimmt sind, in einem Gehäuse (9a, 9b, 9c) des Schutzrahmens (2) montiert und / oder befestigt zu werden, mit mindestens einem Klebstoff verklebt und / oder verclipst ist.

4. Schutzvorrichtung nach einem der Ansprüche 1 bis 3, **dadurch gekennzeichnet, dass** eine Vorrichtung zur Steuerung der Bewegungen des Gelenks zwischen dem Schutzrahmen und der Schutzklappe mindestens ein in ein Gehäuse des Schutzrahmens eingesetztes Metallelement (8a, 8b, 8c) umfasst, in Kontakt mit der metallisierten Schicht und aus diesem hervorstehend, um in Kontakt mit der leitenden Schicht der Schutzklappe zu sein, wenn sich die Schutzklappe in der geschlossenen Position befindet.

5. Schutzvorrichtung nach Anspruch 4, **dadurch gekennzeichnet, dass** die Schutzklappe (3) an ihrer dem Schutzrahmen zugewandten Seite mindestens ein Gehäuse (10a, 10b, 10c) aufweist, so dass dieses Gehäuse zur Aufnahme des aus dem Gehäuse herausragenden Teils des Metallelements angeordnet ist.

6. Schutzvorrichtung nach einem der Ansprüche 1 bis 3, **dadurch gekennzeichnet, dass** eine Vorrichtung zur Steuerung der Bewegungen des Gelenks zwischen dem Schutzrahmen (2) und der Schutzklappe (3) mindestens ein Paar Magnete (5a, 5b, 5c, 5d, 5e, 5f) zur Stabilisierung der Schutzklappe umfasst, in einer offenen oder geschlossenen Position relativ zu dem Zugang innerhalb des Schutzrahmens, **dadurch gekennzeichnet, dass** die elektrische Kontinuität durch den Kontakt eines ersten Magneten, der einerseits an dem Schutzrahmen angebracht ist, und zweitens in Kontakt mit der Metallstruktur des Schutzrahmens mit einem zweiten befestigten Magneten, der an der Schutzklappe befestigt ist und in Kontakt mit der Metallstruktur der Klappe steht.

7. Schutzvorrichtung nach Anspruch 6, **dadurch gekennzeichnet, dass** der Schutzrahmen (2) und die Schutzklappe (3) jeweils mindestens einen Stabilisierungsmagneten der Schutzklappe in einer offenen oder geschlossenen Position relativ zum Schutzrahmen umfassen.

8. Schutzvorrichtung nach Anspruch 6 oder 7, **dadurch gekennzeichnet, dass** mindestens ein Stabilisierungsmagnet in einem Gehäuse (6a, 6b, 6c) angeordnet ist, das in einem der Gehäuseteile angeordnet ist, wobei ein erster Teil des Magneten in Kontakt mit einem zweiten fest angebrachten Magneten steht an dem anderen Teil des Gehäuses, während ein zweiter Teil des Magneten in Kontakt mit einem Verbindungsstück ist, das ebenfalls in Kontakt mit der Metallstruktur ist.

9. Schutzeinrichtung nach einem der Ansprüche 6 bis 8, **dadurch gekennzeichnet, dass**, während ein Magnet der Klappe vor einem Magneten gleicher Polarität integral mit dem Rahmen angeordnet ist, wenn sich die Klappe (3) in der Offenstellung oder in der Schließstellung ausstellt, Ein umgekehrte Polarität des Klappenmagneten Magnet zumindest zwischen den zwei Magneten des Rahmens angeordnet ist, die die zwei offenen und geschlossenen Positionen definieren.

10. Schutzvorrichtung nach einem der Ansprüche 6 bis 9, **dadurch gekennzeichnet, dass** die Magnete (5) mit einer leitfähigen Beschichtung zur Verbesserung der elektrischen Kontinuität zwischen den Magneten und / oder zwischen jedem der Magnete und der Metallstruktur des jeweiligen Teils des Gehäuses, mit welcher der Magnet in Kontakt ist, beschichtet sind.

11. Schutzvorrichtung nach einem der Ansprüche 4 bis 10, **dadurch gekennzeichnet, dass** die Schutzklappe mit dem Schutzrahmen an einer Schwenkachse (4) angelenkt ist.

12. Schutzvorrichtung nach einem der Ansprüche 4 oder 5 und nach Anspruch 11, **dadurch gekennzeichnet, dass** das Metallelement mindestens eine Länge aufweist, die entlang einer Tangente an einem Kreis orientiert ist, der auf der Schwenkachse der Schutzklappe Rahmen (2) zentriert ist.

13. Schutzvorrichtung nach einem der Ansprüche 11 oder 12, **dadurch gekennzeichnet, dass** die Schwenkachse (4) in einer Richtung senkrecht zur Ebene der Schutzklappe positioniert ist, so dass die Verschwenkung parallel zur Ebene der Schutzklappe und zur Ebene ist, wobei des Schutzrahmens der Schutzverschluss auf dem Schutzrahmen von einer offenen Position in eine geschlossene Position in derselben Ebene schwenkt.

14. Schutzvorrichtung nach einem der Ansprüche 11 oder 12, **dadurch gekennzeichnet, dass** die Drehachse entlang einer zur Ebene der Schutzklappe parallelen Achse angeordnet ist, so dass die Drehung der Schutzklappe (3) um die Drehachse erfolgt, wobei die Schutzklappe von einer offenen Position in eine geschlossene Position rotiert, wo sie gegen den Schutzrahmen gefaltet wird.

15. Schutzvorrichtung nach einem der Ansprüche 4 bis 12, **dadurch gekennzeichnet, dass** die Schutzklappe (3) an dem Schutzrahmen angebracht ist, um sich axial von einer offenen Position in eine geschlossene Position zu bewegen.

## Claims

1. Protective device against electromagnetic waves emitted by a mobile terminal forming a housing (1) comprising at least one metal protection face adapted to surround the terminal and this housing comprising at least a first piece arranged to define a metal protective frame (2) intended to receive the terminal and a second piece which forms a removable protective flap (3) articulating with the frame of the first part to seal at least one protective face of the protective case (1), **characterized in that** the first piece (2) and the second piece (3) of the protective device are associated with a device connecting the metal structure of each of the parts of the protective housing to allow electrical continuity between the two parts and ensure the electromagnetic sealing of the protective device when the flap is closed on the protective frame, this device electrical continuity being incorporated in one of the elements of a device for controlling the movements of the hinge of the protective flap with the protective frame.

2. Protective device according to claim 1, **characterized in that**, the surface of the housing parts being coated with a non-conductive covering element, the electrical continuity device passes through the coating to be in contact with the conductive metal structure of each of the parts of the case.

3. Protective device according to any of claims 1 to 2, **characterized in that** at least one of the electrical continuity elements intended to be mounted and / or fixed in a housing (9a, 9b, 9c) of the protective frame (2) is glued and / or clipped with at least one adhesive conductive.

4. Protective device according to any of claims 1 to 3, **characterized in that** a device for controlling the movements of the articulation between the protective frame and the protective flap comprises at least one metal element (8a, 8b, 8c) inserted into a housing of the protective frame (2) in contact with the metallized layer and protruding from this housing to be in contact with the conductive layer of the protective flap when the protective flap is in the closed position.

5. Protective device according to claim 4, **characterized in that** the protective flap (3) comprises at least one housing (10a, 10b, 10c) on its side facing the protective frame so that this housing is arranged to receive the portion of the metal element which protrudes from the housing of the corresponding frame.

6. Protective device according to one of claims 1 to 3, **characterized in that** a device for controlling the movements of the articulation between the protective frame (2) and the protective flap (3) comprises at least one pair of magnets (5a, 5b, 5c, 5d, 5e, 5f) for stabilizing the protective flap in an open or closed position relative to the access inside the protective frame (2), **characterized in that** the electrical continuity is operated by the contact of a first magnet on the one hand mounted on the protective frame and on the other hand in contact with the metal structure of the protective frame with a second magnet fixed to the protective flap and in contact with the metal structure of the flap.

7. Protective device according to claim 6, **characterized in that** the protective frame (2) and the protective flap (3) each have at least one stabilizing magnet of the protective flap in an open or closed position relative to the protective frame.

8. Protective device according to claim 6 or 7, **characterized in that** at least one stabilizing magnet is positioned in a housing (6a, 6b, 6c) disposed in one part of the housing, a first portion of the magnet being in contact with a second magnet fixed on the other part of the housing, while a second part of the magnet is in contact with a connecting piece also in contact with the metal structure.

9. Protective device according to any of claims 6 to 8, **characterized in that**, a first magnet of the flap being disposed in front of a magnet of the same polarity integral with the frame when the flap (3) is in the open position or in the closed position, a magnet of reverse polarity of that of the flap magnet is disposed at least between the two magnets of the frame defining the two open and closed positions.

10. Protective device according to any of claims 6 to 9, **characterized in that** the magnets are coated with a conductive coating to improve electrical continuity between the magnets and / or between each of the magnets and the metal structure of the respective part of the housing with which magnet is in contact.

11. Protective device according to any of claims 4 to 10, **characterized in that** the protective flap is articulated with the protective frame at a pivot axis (4).

12. Protective device according to one of claims 4 or 5 and according to claim 11, **characterized in that** the metal element has at least one length oriented along a tangent to a circle centered on the pivot axis of the protective flap with the frame (2).

13. Protective device according to one of claims 1 1 or 12, **characterized in that** the pivot axis (4) is positioned in a direction perpendicular to the plane of the protective flap, so that the pivoting is parallel to the plane of the protective flap (3) and to the plane of the protective frame (2), the protective shutter pivots on the protective frame from an open position to a closed position in the same plane.

14. Protective device according to one of claims 1 1 or 12, **characterized in that** the axis of rotation is positioned along an axis parallel to the plane of the protective flap (3), so that the rotation of the protective flap takes place around said axis of rotation. rotation, the protective flap rotating from an open position to a closed position where it is folded against the protective frame.

15. Protective device according to one of claims 4 to 12, **characterized in that** the protective flap is mounted on the protective frame to translate axially from an open position to a closed position.
